# EUROPEAN PATENT SPECIFICATION

(11) **EP 1 157 783 B1**
(45) Date of publication and mention of the grant of the patent: **06.01.2010**
(21) Application number: 01113008.5
(22) Date of filing: 28.05.2001
(51) Int. Cl.: B24B 37/04

(54) **Polishing method and polishing apparatus**
Polierverfahren und Vorrichtung
Procédé et dispositif de polissage

(30) Priority: 26.05.2000 JP 2000156690
(43) Date of publication of application: 28.11.2001
(73) Proprietor: EBARA CORPORATION, Ohta-ku, Tokyo (JP)
(72) Inventor: Torii, Hiroomi, c/o Ebara Corporation, Tokyo (JP); Kojima, Hiroshi, c/o Ebara Corporation, Tokyo (JP); Ogura, Suguru, c/o Ebara Corporation, Tokyo (JP); Isobe, Soichi, c/o Ebara Corporation, Tokyo (JP)
(74) Representative: Wagner, Karl H.

(56) References cited:
- EP-A- 0 990 485

## Description

### BACKGROUND OF THE INVENTION

### Field of the Invention:

The present invention relates to a polishing method and apparatus, and more particularly to a polishing method and apparatus for polishing a workpiece such as a semiconductor wafer to a flat mirror finish.

### Description of the Related Art:

Recent rapid progress in semiconductor device integration demands smaller and smaller wiring patterns or interconnections and also narrower spaces between interconnections which connect active areas. One of the processes available for forming such interconnection is photolithography. Although the photolithographic process can form interconnections that are at most 0.5 *µ*m wide, it requires that surfaces on which pattern images are to be focused by a stepper be as flat as possible because the depth of focus of the optical system is relatively small. However, conventional apparatuses for planarizing semiconductor wafers (substrate-like workpieces), such as self-planarizing CVD apparatus or etching apparatus, fail to produce completely planarized surfaces on semiconductor wafers. Recently, it has been attempted to planarize semiconductor wafers with a polishing apparatus which is expected to achieve easily complete planarization of the semiconductor wafers as compared with the above conventional apparatuses. Such a process is called Chemical Mechanical Polishing (CMP) in which the semiconductor wafers are chemically and mechanically polished while supplying a polishing liquid comprising abrasive particles and chemical solution such as alkaline solution.

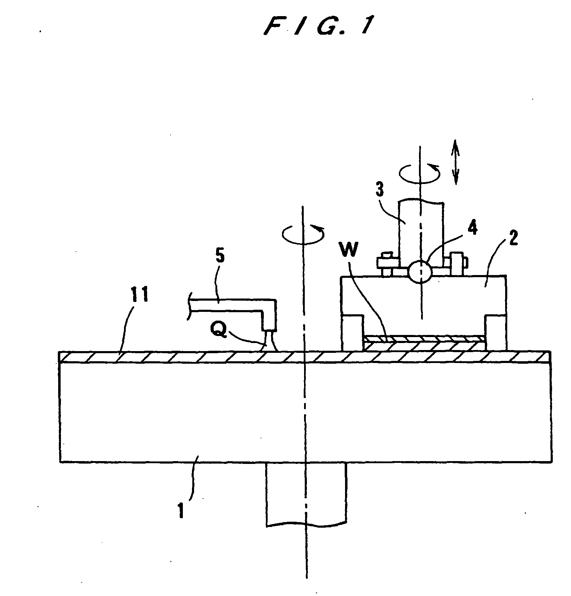

FIG. 1 is a schematic view showing the basic structure of this type of polishing apparatus. As shown in FIG. 1, the polishing apparatus has a turntable 1 with a polishing cloth 11 attached thereon and constituting a polishing surface, and a top ring 2 for holding a semiconductor wafer (workpiece) W in such a manner that the surface, to be polished, of the semiconductor wafer W faces the turntable 1. The top ring 2 is connected to a lower end of a top ring shaft 3 via a ball joint 4 so as to be tiltable with respect to the top ring shaft 3. The semiconductor wafer W to be polished is pressed against the turntable 1 under a certain pressure by the top ring 2 while the turntable 1 and the top ring 2 are independently being rotated, and the surface of the semiconductor wafer W is polished to a flat mirror finish while a polishing liquid Q is being supplied from a polishing liquid supply nozzle 5. In this case, the surface, to be polished, of the semiconductor wafer W is brought into sliding contact with the upper surface of the polishing cloth 11 while following the inclination of the upper surface of the polishing cloth 11 via the ball joint 4.

As a polishing cloth attached on a turntable, a polishing cloth made of non-woven fabric has heretofore been employed. Higher levels of integration achieved in recent years for ICs and LSI circuits demand smaller steps or surface irregularities on the polished surface of the semiconductor wafer. In order to meet such a demand, there has been used a polishing cloth made of a hard material such as polyurethane foam.

After the semiconductor wafer W is polished by the polishing apparatus, it is necessary to remove the semiconductor wafer W from the polishing surface (the polishing cloth 11) on the turntable 1. However, a large surface tension acts between the polishing cloth 11 and the semiconductor wafer W due to the polishing liquid Q interposed therebetween. Accordingly, if the top ring 2 holding the semiconductor wafer W is lifted at the polishing position in order to remove the semiconductor wafer W from the polishing cloth 11, there are some cases that only the top ring 2 is lifted and the semiconductor wafer W adheres to the polishing cloth 11 to be left on the polishing cloth 11.

Such a problem can be solved by an overhanging action of the top ring. In the overhanging action, after the polishing process is completed, the top ring 2 is not lifted at the polishing position, but is moved to the outer circumferential edge of the polishing cloth 11 to partly expose the polished surface of the semiconductor wafer W beyond the outer circumferential edge of the polishing cloth 11 and then lifted to remove the semiconductor wafer W from the polishing cloth 11. This overhanging action allows the surface tension between the polishing cloth 11 and the semiconductor wafer W to be reduced, and the semiconductor wafer W can reliably be separated or removed from the polishing cloth 11.

As described above, with the overhanging action, the surface tension between the polishing cloth 11 and the semiconductor wafer W can be reduced. However, the top ring 2 may tilt when the polished semiconductor wafer W projects from the outer circumferential edge of the polishing cloth 11. In this case, the semiconductor wafer W is intensively pressed at the outer circumferential edge of the polishing cloth 11, so that the semiconductor wafer W is cracked or scratched.

The polishing capability of the polishing cloth is gradually deteriorated due to a deposit of abrasive particles and ground-off particles of the semiconductor material, and due to changes in the characteristics of the polishing cloth. Therefore, if the same polishing cloth is used to repeatedly polish semiconductor wafers, the polishing rate of the polishing apparatus is lowered, and the polished semiconductor wafers tend to suffer polishing irregularities. Therefore, it has been customary to condition the polishing cloth according to a process called "dressing" for recovering the surface of the polishing cloth with a diamond dresser or the like before, or after, or during polishing.

When the diamond dresser dresses the polishing surface of the polishing cloth 11, it scrapes a thin layer off the polishing cloth 11. Therefore, after the polishing surface of the polishing cloth has been dressed many times, it becomes irregular, i.e., loses its planarity, causing formation of steps. As a result, during the movement of the polished semiconductor wafer W to the outer circumferential edge of the polishing cloth 11 in the aforementioned overhanging action, the semiconductor wafer W may be cracked or scratched because of the irregularities of the polishing cloth 11.

Further, attention is drawn to EP 0 990 485 A ('485), which shows a method for releasing semiconductor wafers from a polishing pad, wherein a slurry is applied to a polishing pad, the polishing pad having slurry thereon is rotated while applying pressure against a wafer such that the wafer is polished by the slurry, water is introduced to the polishing pad, the rotational speed of the polishing pad is increased to remove a portion of the slurry, the pressure during the step of increasing rotational speed is decreased to substantially prevent further polishing and finally the wafer is removed from the polishing pad. The increase in the rotational speed causes removal of a portion of the slurry.

### SUMMARY OF THE INVENTION

The present invention has been made in view of the above drawbacks. It is therefore an object of the present invention to provide a polishing method and apparatus which can easily and safely remove a polished workpiece from a polishing surface, and can increase a throughput.

In accordance with the present invention, a polishing method and a polishing apparatus as set forth in claims 1 and 7, respectively are provided. Further embodiments of the invention are claimed in the dependent claims.

There is provided a polishing method comprising: rotating a turntable having a polishing surface thereon, and a top ring for holding a workpiece to be polished, respectively; pressing a surface, to be polished, of the workpiece held by vacuum attraction of the top ring against the polishing surface on the turntable to polish the workpiece; increasing a relative speed of the turntable and the top ring when the polished workpiece held by the top ring is to be removed from the polishing surface on the turntable, in comparison with a relative speed of the turntable and the top ring at a period of polishing; measuring and monitoring a vacuum pressure of said top ring, and judging dislodgement of said workpiece from said top ring, if pressures larger than a predetermined pressure value, at which said workpiece is judged to be normally held by said vacuum attraction of said top ring; are measured for a predetermined period.

According to a preferred aspect of the present invention, a rotational speed of the turntable is increased in comparison with a rotational speed of the turntable at a period of polishing to increase the relative speed of the turntable and the top ring.

According to another preferred aspect of the present invention, rotational speeds of the turntable and the top ring are respectively increased in comparison with rotational speeds of the turntable and the top ring at a period of polishing to increase the relative speed of the turntable and the top ring.

There is also provided a polishing apparatus for polishing a workpiece to be polished, comprising: a turntable having a polishing surface thereon; a top ring for holding the workpiece to be polished and pressing the workpiece against the polishing surface on the turntable; a motor for rotating the top ring; a vacuum pressure sensor for measuring and monitoring a vacuum pressure of said top ring and a controller for controlling a rotational speed of the motor; wherein when the polished workpiece held by the top ring is to be removed from the polishing surface on the turntable, the motor increases a rotational speed of the top ring in comparison with a rotational speed of the top ring at a period of polishing, and wherein dislodgement of said workpiece from said top ring is judged, if pressures larger than a predetermined pressure value, at which said workpiece is judged to be normally held by said vacuum attraction of said top ring, are measured for a predetermined period by said vacuum pressure sensor.

It is desirable that the rotational speed of the turntable be increased to 100 min⁻¹ or larger, and the rotational speed of the top ring be increased to 75 min⁻¹ or larger.

According to the present invention, the liquid film thickness of a polishing liquid on the polishing surface is decreased by the action of the centrifugal force, so that the surface tension due to the polishing liquid is reduced. Therefore, even if the top ring is lifted at the polishing position without an overhanging action, the workpiece can easily be removed from the polishing surface. Thus, the present invention can prevent the workpiece from being left on the polishing surface and being cracked or scratched. Further, since it is not necessary to perform the overhanging action, tact time for polishing can be reduced to increase a throughput. Furthermore, when the rotational speed of the turntable is increased, the components of the polishing liquid are scattered and discharged from the upper surface of the turntable by the action of the centrifugal force. Accordingly, it becomes easier to remove the workpiece from the polishing surface, and simultaneously the polishing conditions for the next workpiece to be polished can be arranged to be preferred conditions. As a result, the throughput can be increased.

The above and other objects, features, and advantages of the present invention will be apparent from the following description when taken in conjunction with the accompanying drawings which illustrates preferred embodiments of the present invention by way of example.

### BRIEF DESCRIPTION OF THE DRAWINGS

- FIG. 1: is a schematic view showing the basic structure of a polishing apparatus;
- FIG. 2: is a front view showing the whole structure of a polishing apparatus according to an embodiment of the present invention; and
- FIG. 3: is a schematic view showing a mechanism for vacuum attraction of a wafer according to an embodiment of the present invention;
- FIGS. 4A and 4B: are schematic views showing an overhanging action; and
- FIG. 5: is a schematic view showing a polishing apparatus according to another embodiment of the present invention.

### DETAILED DESCRIPTION OF THE PREFERRED EMBODIMENTS

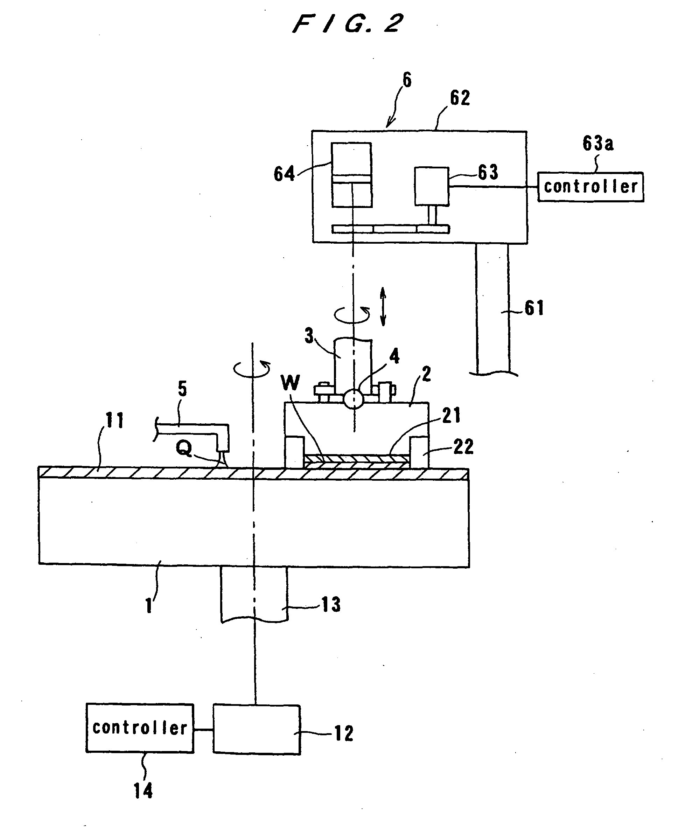

A polishing method and apparatus according to an embodiment of the present invention will be described below with reference to FIG. 2. FIG. 2 is a front view showing the whole structure of a polishing apparatus according to an embodiment of the present invention. In FIG. 2, like parts and components are designated by the same reference numerals and characters as those shown in FIG. 1.

As shown in FIG. 2, the polishing apparatus according to the present embodiment comprises a turntable 1, a polishing liquid supply nozzle 5, and a top ring unit 6. The turntable 1 has a vertical shaft 13 coupled to a motor 12 disposed below the turntable 1 and is rotatable about the shaft 13, as indicated by an arrow in FIG. 1. The motor 12 is connected to a controller 14 for controlling a rotational speed of the motor 12. A polishing cloth 11 is attached on an upper surface of the turntable 1. The polishing cloth 11 has an upper polishing surface held in sliding contact with a semiconductor wafer W (workpiece) to be polished. The polishing liquid supply nozzle 5 is disposed above the turntable 1, and a polishing liquid Q is supplied onto the polishing cloth 11 of the turntable 1 from the polishing liquid supply nozzle 5.

In the present embodiment, as described above, the turntable 1 has the polishing cloth 11 attached thereon. However, the turntable 1 is not limited to the above one, and the turntable 1 may comprise a polishing plate of a fixed abrasive, for example. The fixed abrasive comprises abrasive particles fixed by a binder.

As shown in FIG. 2, the top ring unit 6 mainly comprises a swing shaft 61, an arm-shaped top ring head 62 connected to the swing shaft 61, and a top ring 2 connected to a top ring shaft 3 extended downwardly from the top ring head 62. The top ring head 62 is swingable in a horizontal plane by rotation of the swing shaft 61. The top ring 2 is connected to the lower end of the top ring shaft 3 via a ball joint 4 so as to be tiltable with respect to the top ring shaft 3.

The top ring 2 of the top ring unit 6 has, on a lower surface thereof, an elastic pad 21 formed of polyurethane or the like. The semiconductor wafer W is attracted to a lower surface of the elastic pad 21 under a vacuum in such a state that the semiconductor wafer W is brought into contact with the lower surface of the elastic pad 21, so that the semiconductor wafer W is held by the top ring 2. The top ring 2 has a cylindrical guide ring 22 at an outer circumferential edge of a lower portion thereof. A lower portion of the guide ring 22 protrudes from the top ring 2, and hence a recess is formed at the radially inner side of the lower portion of the guide ring 22. The semiconductor wafer W is held in the recess for preventing the semiconductor wafer W from being dislodged from the lower surface of the top ring 2 during the polishing process.

The top ring 2 is coupled to a motor 63 provided in the top ring head 62 via the top ring shaft 3, and is rotatable about the top ring shaft 3. The motor 63 is connected to a controller 63a for controlling a rotational speed of the motor 63. The top ring 2 is also coupled to a lifting/lowering cylinder 64 via the top ring shaft 3, and is vertically movable for pressing the semiconductor wafer W held in the top ring 2 against the polishing cloth 11 under a predetermined pressure.

In the polishing apparatus thus constructed, the semiconductor wafer W held on the lower surface of the elastic pad 21 attached on the lower surface of the top ring 2 is pressed against the polishing cloth 11 on the turntable 1, while the polishing liquid Q is being supplied onto the polishing cloth 11 of the turntable 1 from the polishing liquid supply nozzle 5. The turntable 1 and the top ring 2 are independently rotated, so that the polishing cloth 11 and the semiconductor wafer W are moved relative to each other. For example, a suspension of fine polishing particles of silica or the like in an alkali solution is used as the polishing liquid supplied from the polishing liquid nozzle 5. Thus, the semiconductor wafer W is polished to a flat mirror finish by the combined effect of a chemical polishing effect attained by the alkali and a mechanical polishing effect attained by the polishing particles.

The semiconductor wafer W is polished in the above manner. After the polishing process of the semiconductor wafer W is completed, it is necessary to separate or remove the semiconductor wafer W from the polishing cloth 11 on the turntable 1. In this case, the surface tension acts between the polishing cloth 11 and the semiconductor wafer W, as described above. According to the present invention, when the semiconductor wafer W is to be separated or removed from the polishing cloth 11, the rotational speeds of the turntable 1 and the top ring 2 are increased by the motor 12 and the motor 63 in comparison with their rotational speeds at a period of the polishing process. As a result, reduction of the surface tension can be achieved as follows:
Specifically, when the rotational speeds of the turntable 1 and the top ring 2 are increased, the liquid film thickness of the polishing liquid Q on the polishing cloth 11 is decreased by the action of the centrifugal force, so that the surface tension due to the polishing liquid Q is reduced. Therefore, even if the top ring 2 is lifted at the polishing position without an overhanging action, the semiconductor wafer W can easily be removed from the polishing cloth 11. Thus, the present invention can prevent the semiconductor wafer W from being left on the polishing cloth 11 and being cracked or scratched. Further, since it is not necessary to perform the overhanging action, tact time for polishing can be reduced to increase a throughput. Furthermore, when the rotational speed of the turntable 1 is increased by the motor 12, the components of the polishing liquid are scattered and discharged from the upper surface of the turntable 1 by the action of the centrifugal force. Accordingly, it becomes easier to remove the semiconductor wafer from the polishing surface, and simultaneously the polishing conditions for the next semiconductor wafer to be polished can be arranged to be preferred conditions. As a result, the throughput can be increased.

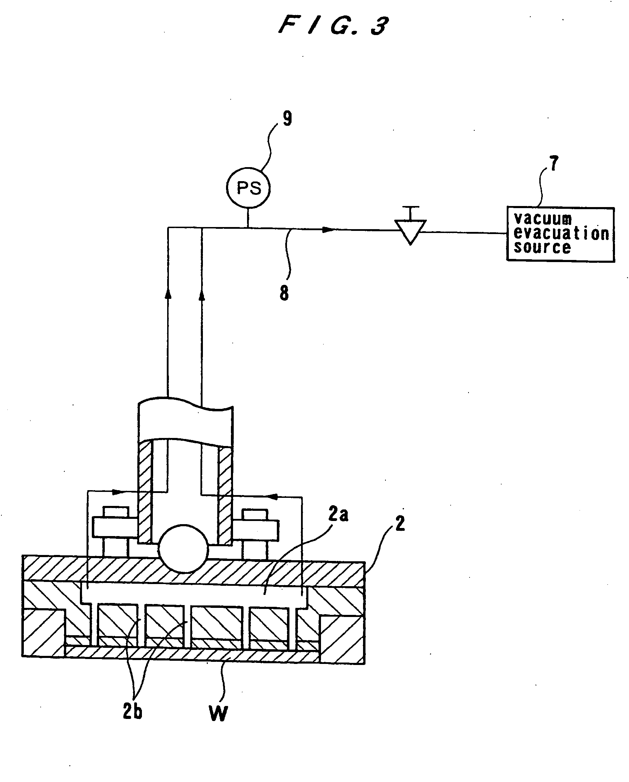

In the present embodiment, as shown in FIG. 3, a vacuum line 8 communicating with a vacuum evacuation source 7 is connected to the top ring 2. The top ring 2 has a chamber (or a space) 2a connected to the vacuum line 8, and a plurality of holes 2b communicating with the chamber 2a and being open to the lower surface of the top ring 2. Thus, the semiconductor wafer W is held on the lower surface of the top ring 2 by vacuum attraction. When the semiconductor wafer W is to be removed from the polishing cloth 11, the top ring 2 is mechanically lifted. If the semiconductor wafer W is dislodged from the top ring 2 and is left on the polishing cloth 11, the pressure of the vacuum line 8 changes from a vacuum nearer to the atmospheric pressure. Therefore, the pressure of the vacuum line 8 is monitored to judge whether the semiconductor wafer W has normally been removed from the polishing cloth 11 or not.

In the present embodiment, as shown in FIG. 3, a vacuum pressure sensor 9 is provided in the vacuum line 8 to measure and monitor the pressure of the vacuum line 8, for thereby judging whether the semiconductor wafer W has normally been removed from the polishing cloth 11 or not. Specifically, after the lifting operation of the top ring 2 is started, the pressure of the vacuum line 8 is measured with the vacuum pressure sensor 9. If the measured value is less than a predetermined pressure value, it is judged that the semiconductor wafer W has normally been removed from the polishing cloth 11 in such a state that the semiconductor wafer W is attracted to the top ring 2. More specifically, if pressures that are 10 kPa or more larger than the predetermined pressure value, at which the semiconductor wafer W is judged to be normally attracted to the top ring 2, are measured for a predetermined period or longer, then it is judged that the semiconductor wafer W has been dislodged from the top ring 2.

Experiments were carried out as follows:
A strain gauge was provided in the top ring, and the rotational speeds of the turntable and the top ring were respectively changed when the semiconductor wafer was to be removed from the polishing cloth. An axial force acting on the top ring at this time, i.e., a force for lifting the top ring, was measured.
* A top ring for holding a semiconductor wafer having a diameter of 200 mm was used.
* Dressing was performed for 600 seconds by a dresser before a polishing process.
* After three semiconductor wafers were polished as dummies to obtain the normal condition of the polishing cloth, two semiconductor wafers were polished for measuring a force for lifting the top ring. The force for lifting the top ring was calculated based on the average of the values measured after polishing of the two semiconductor wafers.
* During the polishing process, the rotational speed of the turntable was 22 min⁻¹, and the rotational speed of the top ring was 16 min⁻¹.
* When the semiconductor wafer was lifted, the rotational speed of the turntable was changed to 50 min⁻¹, 75 min⁻¹ or 100 min⁻¹, and the rotational speed of the top ring was changed to 55 min⁻¹ or 75 min⁻¹.
* As the dresser, a new dresser and a used dresser that had already used for processing 17,000 semiconductor wafers were used in the experiments, respectively.

The measurement results in the above experiments are shown in Table 1.

**Table 1**

| Rotational speed of turntable (min⁻¹) | Rotational speed of top ring (min⁻¹) | Force for lifting top ring in the case of new dresser (N) | Force for lifting top ring in the case of used dresser (N) |
|---|---|---|---|
| 50 | 55 | 332.1 | 342 |
| 75 | 55 | 99.9 | 378.9 |
| 100 | 55 | 378 | 185.4 |
| 50 | 75 | 389.7 | 300.9 |
| 75 | 75 | 338.7 | 178.8 |
| 100 | 75 | 25.9 | 96.6 |

From Table 1, it is shown that, in both cases of the new dresser and the used dresser, when the rotational speed of the turntable and the rotational speed of the top ring at a period of lifting a semiconductor wafer were the largest, i.e., when the rotational speed of the turntable was 100 min⁻¹, and the rotational speed of the top ring 75 min⁻¹, the force for lifting the top ring was the lowest. In this case, the semiconductor wafer W could easily be lifted from the polishing cloth 11.

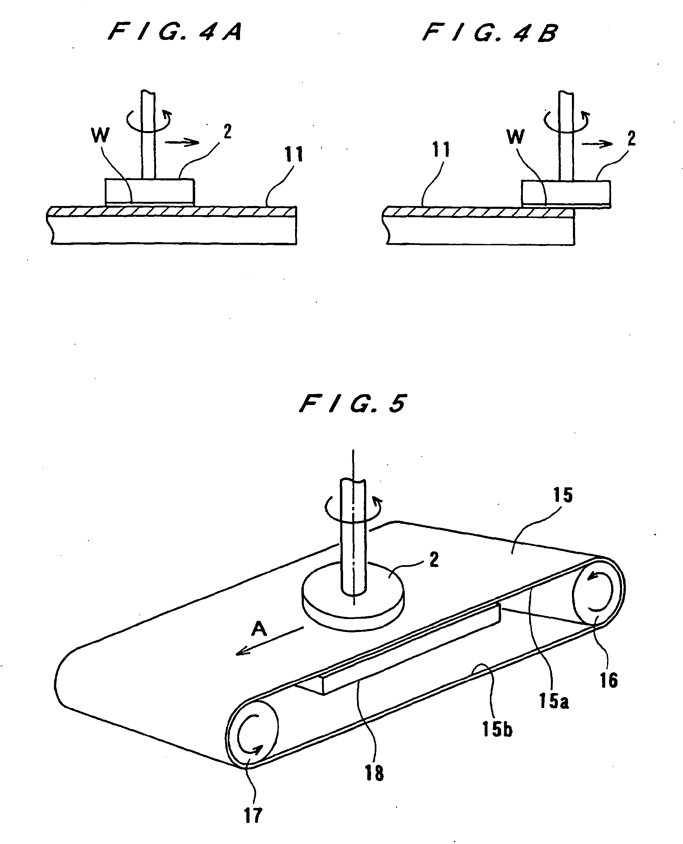

In the present embodiment, the top ring 2 is lifted at the polishing position without an overhanging action. However, the top ring 2 may perform an overhanging action after the polishing process, as shown in FIGS. 4A and 4B. After the polishing process is completed, the top ring 2 is moved to the outer circumferential edge of the polishing cloth 11 to partly expose the polished surface of the semiconductor wafer W beyond the outer circumferential edge of the polishing cloth 11 and then lifted to remove the semiconductor wafer W from the polishing cloth 11. When the semiconductor wafer W is to be separated or removed from the polishing cloth 11, the rotational speed of the top ring 2 is increased in comparison with the rotational speed at a period of the polishing process. The liquid film thickness of the polishing liquid on the polishing cloth 11 is decreased by the action of the centrifugal force, so that the surface tension due to the polishing liquid is reduced by the synergistic effect of the centrifugal force and the overhanging action. Therefore, the semiconductor wafer W can more easily be removed from the polishing surface. As a result, the semiconductor wafer W can be prevented from being left on the polishing surface 18 more effectively.

In the present embodiment, the polishing surface is rotated to polish the semiconductor wafer. However, the polishing surface and the top ring may be moved relative to each other. In FIG. 5, a polishing surface is constituted by a belt 15 having abrasive particles on its surface. The belt 15 is wound on two rotatable drums 16, 17. The drums 16, 17 are rotated to linearly move the belt 15 along an arrow A. A support 18 is disposed between an upper belt surface 15a and a lower belt surface 15b. A semiconductor wafer held by the top ring 2 is pressed against the belt 15 and the support 18. Thus, the semiconductor wafer is polished. When the semiconductor wafer is to be separated or removed from the belt 15, the rotational speed of the top ring 2 is increased in comparison with the rotational speed at a period of the polishing process. As in the case of the aforementioned embodiment, the semiconductor wafer can be prevented from being left on the belt 15 (polishing surface).

As described above, according to the present invention, when a polished workpiece held by a top ring is to be removed from a polishing surface on a turntable, a rotational speed of the turntable is increased in comparison with a rotational speed of the turntable at a period of polishing. A relative speed of the turntable and the top ring is increased in comparison with a relative speed of the turntable and the top ring at a period of polishing. Hence, even if the top ring is lifted at the polishing position without an overhanging action, the workpiece can easily be removed from the polishing surface. Thus, the present invention can prevent the workpiece from being left on the polishing surface and being cracked or scratched. Further, since it is not necessary to perform the overhanging action, tact time for polishing can be reduced to increase a throughput. Furthermore, when the rotational speed of the turntable is increased, the components of the polishing liquid are scattered and discharged from the upper surface of the turntable by the action of the centrifugal force. Accordingly, it becomes easier to remove the workpiece from the polishing surface, and simultaneously the polishing conditions for the next workpiece to be polished can be arranged to be preferred conditions. As a result, the throughput can be increased.

Although certain preferred embodiments of the present invention have been shown and described in detail, it should be understood that various changes and modifications may be made therein without departing from the scope of the appended claims.

## Claims

1. A polishing method comprising:
rotating a turntable (1) having a polishing surface thereon, and a top ring (2) for holding a workpiece (W) to be polished, respectively;
pressing a surface, to be polished, of said workpiece (W) held by said top ring (2) against said polishing surface on said turntable (1) to polish said workpiece (W):
increasing a relative speed of said turntable (1) and said top ring (2) when said polished workpiece (W) held by vacuum attraction of said top ring (2) is to be removed from said polishing surface on said turntable (1), in comparison with a relative speed of said turntable (1) and said top ring (2) at a period of polishing;
measuring and monitoring a vacuum pressure of said top ring (2); and
judging dislodgement of said workpiece (W) from said top ring (2), if pressures larger than a predetermined pressure value, at which said workpiece (W) is judged to be normally held by said vacuum attraction of said top ring (2), are measured for a predetermined period.

2. A polishing method according to claim 1, wherein a rotational speed of said turntable (1) is increased in comparison with a rotational speed of said turntable (1) at a period of polishing to increase said relative speed of said turntable (1) and said top ring (2).

3. A polishing method according to claim 2, wherein said rotational speed of said turntable (1) is increased to 100 min⁻¹ or larger.

4. A polishing method according to claim 1, wherein rotational speeds of said turntable (1) and said top ring (2) are respectively increased in comparison with rotational speeds of said turntable (1) and said top ring (2) at a period of polishing to increase said relative speed of said turntable (1) and said top ring (2).

5. A polishing method according to claim 4, wherein said rotational speed of said top ring (2) is increased to 75 min⁻¹ or larger.

6. A polishing method according to claim 5, wherein said rotational speed of said turntable (1) is increased to 100 min⁻¹ or larger.

7. A polishing apparatus for polishing a workpiece (W) to be polished, comprising:
a turntable (1) having a polishing surface thereon;
a top ring (2) for holding said workpiece to be polished and pressing said workpiece (W) against said polishing surface on said turntable (1);
a motor (12) for rotating said top ring (2);
a vacuum pressure sensor (9) for measuring and monitoring a vacuum pressure of said top ring (2);
a controller for controlling a rotational speed of said motor (12);
wherein when said polished workpiece (W) held by vacuum attraction of said top ring (2) is to be removed from said polishing surface on said turntable (1), said motor increases a rotational speed of said top ring in comparison with a rotational speed of said top ring (2) at a period of polishing; and
wherein dislodgement of said workpiece (W) from said top ring (2) is judged, if pressures larger than a predetermined pressure value, at which said workpiece (W) is judged to be normally held by said vacuum attraction of said top ring (2), are measured for a predetermined period by said vacuum pressure sensor (9).

8. A polishing apparatus according to claim 7, wherein said motor increases said rotational speed of said top ring (2) to 75 min⁻¹ or larger.

## Patentansprüche

1. Ein Polierverfahren, das folgendes aufweist:
Drehen eines Drehtischs (1) mit einer Polieroberfläche darauf, bzw. eines Toprings (2) zum Halten eines zu polierenden Werkstücks (W);
Drücken einer zu polierenden Oberfläche des Werkstücks (W), das durch den Topring (2) gehalten wird, gegen die Polieroberfläche auf dem Drehtisch (1), um das Werkstück (W) zu polieren;
Erhöhen einer Relativgeschwindigkeit des Drehtischs (1) und des Toprings (2), wenn das zu polierende Werkstück (W), das durch Vakuumanziehung des Toprings (2) gehalten wird, von der Polieroberfläche des Drehtischs (1) entfernt werden soll, und zwar im Vergleich zu einer relativen Geschwindigkeit des Drehtischs (1) und des Toprings (2) während einer Polierperiode;
Messen und Überwachen eines Vakuumdrucks des Toprings (2); und
Beurteilen eines Lösens des Werkstücks (W) von dem Topring (2), wenn Drücke größer als ein vorbestimmter Druckwert, bei denen das Werkstück normalerweise durch die Vakuumansaugung des Toprings (2) gehalten wird, für eine vorbestimmte Periode gemessen werden.

2. Polierverfahren nach Anspruch 1, wobei eine Drehgeschwindigkeit des Drehtischs (1) erhöht wird im Vergleich zu einer Drehgeschwindigkeit des Drehtischs (1) während einer Polierperiode, um die Relativgeschwindigkeit des Drehtischs (1) und des Toprings (2) zu erhöhen.

3. Polierverfahren nach Anspruch 2, wobei die Drehgeschwindigkeit des Drehtischs (1) auf 100 min⁻¹ oder größer erhöht wird.

4. Polierverfahren nach Anspruch 1, wobei Drehgeschwindigkeiten des Drehtischs (1) bzw. des Toprings (2) erhöht werden im Vergleich mit Drehgeschwindigkeiten des Drehtischs (1) bzw. des Toprings (2) während einer Polierperiode, um die Relativgeschwindigkeit des Drehtischs (1) und des Toprings (2) zu erhöhen.

5. Polierverfahren nach Anspruch 4, wobei die Drehgeschwindigkeit des Toprings (2) auf 75 min⁻¹ oder größer erhöht wird.

6. Polierverfahren nach Anspruch 5, wobei die Drehgeschwindigkeit des Drehtischs (1) auf 100 min⁻¹ oder größer erhöht wird.

7. Poliervorrichtung zum Polieren eines zu polierenden Werkstücks (W), die folgendes aufweist:
einen Drehtisch (1) mit einer Polieroberfläche darauf;
einen Topring (2) zum Halten des zu polierenden Werkstücks und zum Drücken des Werkstücks (W) gegen die Polieroberfläche auf dem Drehtisch (1);
einen Motor (12) zum Drehen des Toprings (2);
einen Vakuumdrucksensor (9) zum Messen und Überwachen eines Vakuumdrucks des Toprings (2);
eine Steuerung zum Steuern einer Drehgeschwindigkeit des Motors (12), wobei dann wenn das polierte Werkstück (W) das durch Vakuumansaugung des Toprings (2) gehalten wird von der Polieroberfläche des Drehtischs (1) entfernt werden soll, der Motor eine Drehgeschwindigkeit des Toprings im Vergleich mit einer Drehgeschwindigkeit des Toprings (2) während einer Polierperiode erhöht wird; und
wobei ein Lösen des Werkstücks (W) von dem Topring (2) festgestellt wird, wenn Drücke, die größer sind als ein vorbestimmter Druckwert, mit dem das Werkstück (W) normalerweise durch Vakuumansaugung des Toprings (2) gehalten wird, für eine vorbestimmte Periode durch den Vakuumdrucksensor (9) gemessen werden.

8. Poliervorrichtung nach Anspruch 7, wobei der Motor die Drehgeschwindigkeit des Toprings (2) auf 75 min⁻¹ oder größer erhöht wird.

## Revendications

1. Un procédé de polissage comprenant :
la mise en rotation d'une plaque tournante (1) ayant une surface de polissage, et un anneau supérieur (2) destiné à retenir une pièce (W) devant être polie, respectivement ;
le pressage d'une surface devant être polie de ladite pièce (W) retenue par ledit anneau supérieur (2) contre ladite surface de polissage sur ladite plaque tournante (1) pour polir ladite pièce (W) ;
l'augmentation d'une vitesse relative de ladite plaque tournante (1) et dudit anneau supérieur (2) lorsque ladite pièce polie (W) retenue par aspiration dudit anneau supérieur (2) doit être retirée de ladite surface de polissage sur ladite plaque tournante (1), par rapport à une vitesse relative de ladite plaque tournante (1) et dudit anneau supérieur (2) à un moment de polissage;
mesurant et contrôlant une dépression dudit anneau supérieur (2) ; et
déterminer le déplacement de ladite pièce (W) depuis ledit anneau supérieur (2), si des pressions plus fortes qu'une valeur de pression prédéterminée à laquelle ladite pièce (W) est considérée comme étant normalement retenue par ladite aspiration dudit anneau supérieur (2) sont mesurées pendant une période de temps prédéterminée.

2. Un procédé de polissage selon la revendication 1, dans lequel une vitesse de rotation de ladite plaque tournante (1) est augmentée par rapport à une vitesse de rotation de ladite plaque tournante (1) à un moment de polissage de façon à augmenter ladite vitesse relative de ladite plaque tournante (1) et dudit anneau supérieur (2).

3. Un procédé de polissage selon la revendication 2, ladite vitesse de rotation de ladite plaque tournante (1) étant augmentée jusqu'à 100 min⁻¹ ou plus.

4. Un procédé de polissage selon la revendication 1, les vitesses de rotation de ladite plaque tournante (1) et dudit anneau supérieur (2) étant respectivement augmentées par rapport aux vitesses de rotation de ladite plaque tournante (1) et dudit anneau supérieur (2) à un moment de polissage de façon à augmenter ladite vitesse relative de ladite plaque tournante (1) et dudit anneau supérieur (2).

5. Un procédé de polissage selon la revendication 4, ladite vitesse de rotation dudit anneau supérieur (2) étant augmentée jusqu'à 75 min⁻¹ ou plus.

6. Un procédé de polissage selon la revendication 5, ladite vitesse de rotation de ladite plaque tournante (1) étant augmentée jusqu'à 100 min⁻¹ ou plus.

7. Un appareil de polissage destiné à polir une pièce (W) devant être polie, comprenant :
une plaque tournante (1) ayant une surface de polissage ;
un anneau supérieur (2) destiné à retenir ladite pièce devant être polie et à presser ladite pièce (W) contre ladite surface de polissage de ladite plaque tournante (1) ;
un moteur (12) destiné à mettre ledit anneau supérieur (2) en rotation ;
un capteur de pression négative (9) destiné à mesurer et à contrôler une dépression dudit anneau supérieur (2) ;
une commande destinée à commander une vitesse de rotation dudit moteur (12) ;
dans lequel lorsque ladite pièce (W) polie retenue par aspiration dudit anneau supérieur (2) doit être retirée de ladite surface de polissage de ladite plaque tournante (1), ledit moteur augmente une vitesse de rotation dudit anneau supérieur par rapport à une vitesse de rotation dudit anneau supérieur (2) à un moment de polissage,
un déplacement de ladite pièce (W) depuis ledit anneau supérieur (2) étant déterminé si des pressions plus fortes qu'une valeur de pression prédéterminée à laquelle ladite pièce (W) est considérée comme étant normalement retenue par ladite aspiration dudit anneau supérieur (2) sont mesurées pendant une période de temps prédéterminée par lesdits capteurs de pression négative (9).

8. Un appareil de polissage selon la revendication 7, ledit moteur augmentant ladite vitesse de rotation dudit anneau supérieur (2) jusqu'à 75 min⁻¹ ou plus.
